# EUROPEAN PATENT SPECIFICATION

(11) **EP 0 809 291 B1**
(45) Date of publication and mention of the grant of the patent: **04.04.2007**
(21) Application number: 97103728.8
(22) Date of filing: 06.03.1997
(51) Int. Cl.: H01L 23/532, H01L 21/768

(54) **Semiconductor device with intermetal dielectric and method of making**
Halbleiterschaltung mit dielektrischer Schicht zwischen zwei Metallebenen und Verfahren zur Herstellung
Dispositif semi-conducteur diélectrique entre deux couches de métallisation et procédé de fabrication

(30) Priority: 22.03.1996 US 13892
(43) Date of publication of application: 26.11.1997
(73) Proprietor: TEXAS INSTRUMENTS INCORPORATED, Dallas, Texas 75243 (US)
(72) Inventor: Eissa, Mona, Plano, TX 75023 (US)
(74) Representative: Holt, Michael

(56) References cited:
- GB-A- 1 146 005
- US-A- 3 332 891
- DABRAL S ET AL: "A A' A'' A''' POLY-TERTRAFLUORO-P-XYLYLENE AS AN INTERLAYER DIELECTRIC FOR THIN FILM MULTICHIP MODULES AND INTEGRATED CIRCUITS" JOURNAL OF VACUUM SCIENCE AND TECHNOLOGY: PART B, vol. 11, no. 5, 1 September 1993, pages 1825-1832, XP000403660

## Description

### TECHNICAL FIELD OF THE INVENTION

This invention relates in general to the field of electronic devices and more particularly to semiconductor devices having an improved intermetal dielectric and method of formation.

### BACKGROUND OF THE INVENTION

As the features sizes of ULSI technology continue to shrink, the intrinsic semiconductor gate performance improves through a higher drive current and lower junction capacitance. However, the interconnect RC time constant increases rapidly because the resistance of metal leads increases with decreasing line width and the interconnect capacitance increases with decreasing spacing between the lines. When minimum feature size is scaled below 0.3 micron, the interconnect delay becomes a major limiting factor of circuit performance.

The replacement of silicon dioxide as an intermetal dielectric with an insulator of lower dielectric constant is a particularly attractive solution since it provides immediate performance improvement through a reduction in capacitance. Prior techniques have used an imbedded polymer integration scheme to improve the interconnect performance through line-to-line capacitance reduction by using polymer only between tightly spaced lines. These gap-filled polymeric materials do not degrade the electromigration performance of standard multilayered titanium nitride and aluminum interconnects.

There are a variety of dielectric materials including pure polymer, spin-on glasses, and porous materials that offer lower values of permittivity than traditional silicon dioxide. One particularly useful polymer which exhibits extremely low permittivity values and yet exhibits thermal stability is fluorinated poly (para-xylylene), commonly referred to as fluorinated parylene or parylene-F. Parylene-F exhibits a dielectric constant on the order of 2.3. This is in comparison to a dielectric constant of on the order of 2.7 for non-fluorinated parylene, commonly referred to as parylene-N, and a dielectric constant of the order of 4.5 for undoped silicon dioxide.
In the paper DABRAL S ET AL: 'AA'A"A" ' POLY-TERTRAFLUORO-P-XYLYLENE AS ANINTERLAYER DIELECTRIC FOR THIN FILM MULTICHIP MODULES AND INTEGRATED CIRCUITS' JOURNAL OF VACUUM SCIENCE AND TECHNOLOGY: PART B, vol. 11, no. 5, 1 September 1993, pages 1825-1832, XP000403660. The characteristics of these materials are individually analysed by disposition of each separately to a separate substrate for electrical and thermal characterization.

Each of documents US-A-3 332 891 and GB-1 146 005 discloses obtaining perfluorinated poly(para-xylylene) for semiconductor devices.

Although parylene-F performs as an excellent intermetal dielectric, it is extremely difficult to work with because of the difficulty in forming the precursor dimer AF4 which is the reactant needed to the formation of parylene-F. Methods of forming the necessary precursor dimer are extremely difficult to control and have correspondingly low yield rates. As such, the precursor dimer for parylene-F is not commercially available and the use of parylene-F as an intermetal dielectric is not commercially feasible.

### SUMMARY OF THE INVENTION

Accordingly, a need has arisen for an improved intermetal dielectric which is commercially practical and provides for a low permittivity constant while remaining compatible with other processes within a semiconductor device formation.

According to the teachings of the present invention, an intermetal dielectric material is provided that substantially eliminates or reduces problems associated with prior materials and techniques of formation.

The invention is defined in the appended claims.

### BRIEF DESCRIPTION OF THE DRAWINGS

A more complete understanding of the teachings of the present invention may be acquired by referring to the accompanying FIGUREs in which like reference numbers indicate like features and wherein:
FIGURE 1 is an enlarged cross-sectional schematic diagram of a portion of a semiconductor device constructed according to the teachings of the present invention;
FIGURE 2 is a diagram illustrating the chemical processes used to create the intermetal dielectric used in the structures and methods of the present invention; and
FIGURE 3 is a schematic illustration of a chemical vapor deposition system which may be used to construct the semiconductor devices according to the teachings of the present invention.

### DETAILED DESCRIPTION OF THE INVENTION

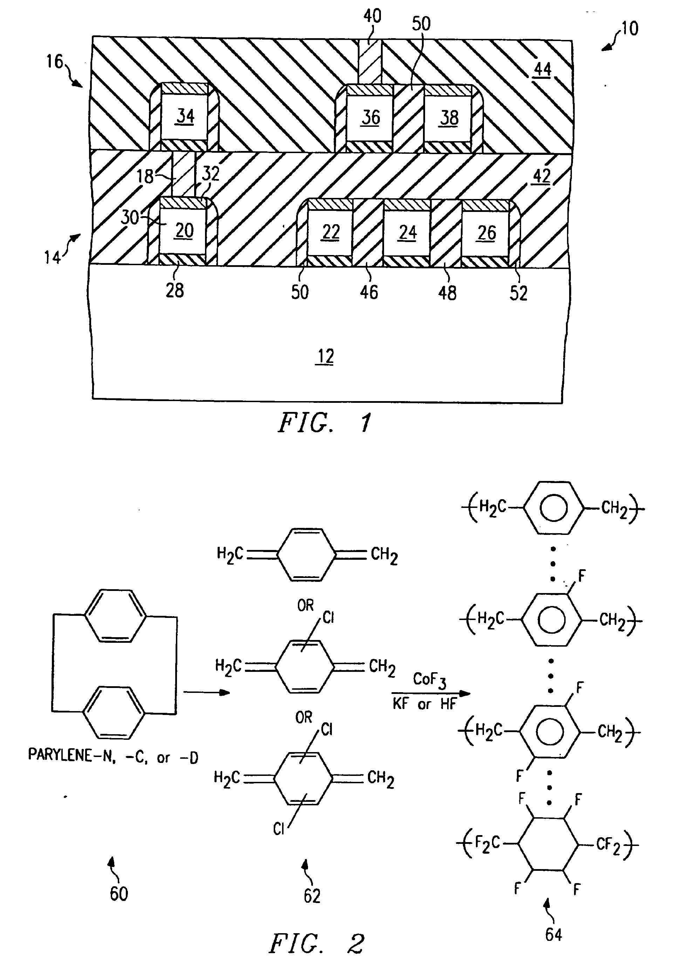

Referring to FIGURE 1, a semiconductor structure indicated generally at 10 is shown which is formed on the outer surface of a semiconductor substrate 12 which may comprise any suitable semiconductor material such as silicon or gallium arsenide.
Semiconductor structure 10 comprises a first level of conductive interconnects indicated generally at 14 and a second level of conductive interconnects indicated generally at 16. Level 14 and level 16 are interconnected by conductive vias represented by via 18 shown in FIGURE 1. Level 14 comprises a network of conductive elements represented by conductive elements 20, 22, 24 and 26. Each of the conductive elements 20, 22, 24 and 26 comprise a composite structure of metal and nitride. For example, conductive element 20 comprises a first level of titanium nitride 28. A layer of aluminum 30 is disposed outwardly from layer 28. Finally, an outer layer of titanium nitride 32 is disposed outwardly from layer 30. Each of conductive elements 20, 22, 24 and 26 are constructed of such a composite formation.

Similarly, layer 16 is comprised of a network of conductors represented by conductive elements 34, 36', and 38. Level 16 may be connected to other outer layers of conductors or devices by conductive via 40. Conductive elements 34, 36 and 38 are each comprised of composite structures similar to that described with reference to element 20 previously.

Level 14 is separated from level 16 and some elements within level 14 are separated from one another by a silicon dioxide layer 42. Similarly, level 16 is separated from layers formed outwardly from level 16 and certain of the elements within layer 16 or separated from one another by a second silicon dioxide layer 44.

According to the teachings of the present invention, conductive elements which are spaced apart by the minimum geometric spacing are not separated by silicon dioxide. For example, conductive elements 22 and 24 are spaced apart by an elongate polymer body 46 shown in FIGURE 1. Similarly, conductive elements 24 and 26 are spaced apart by an elongate polymer body 48. Finally, conductive elements 36 and 38 are spaced apart by an elongate polymer body 50. Polymer bodies 46, 48 and 50 comprise the intermetal dielectric materials, the formation of which will be described herein.

In general, bodies 46, 48 and 50 are formed of a mixture of perfluorinated and non-fluorinated parylene which exhibits a dielectric constant of the order of 2.3. This dielectric constant and the overall performance of the mixed polymeric material is comparable to a fluorinated parylene, commonly referred to as parylene-F. As will be described herein, the mixed polymer material is much easier to form and, as such, is a commercially feasible intermetal dielectric.

The polymer bodies 46, 48 and 50 and formed by a conformal deposition of the mixed polymeric material. This deposition process is followed by an etch-back process. These processes may result in the residual sidewall bodies shown in FIGURE 1 and exemplified by residual sidewall bodies 50 and 52 disposed outwardly from conductive elements 22 and 26 respectively.

FIGURE 2 is a diagram which illustrates the chemical processes that are used to form the mixed polymeric material used in the present invention. Referring to FIGURE 2, a conventional parylene-N, parylene-C or parylene-D dimer indicated at 60 is decomposed to create the reactive monomers indicated generally at 62. These reactive monomers are subjected to an environment which includes fluoride-carrying agents. These fluoride-carrying agents may comprise, for example, cobalt fluoride (CoF₃), potassium fluoride (KF), or hydrogen fluoride (HF). When the monomers associate polymer in the flouride-rich environment, the resulting polymer is a mixture of per-fluorinated and non-fluorinated parylene. This mixture is indicated at 64 in FIGURE 2.

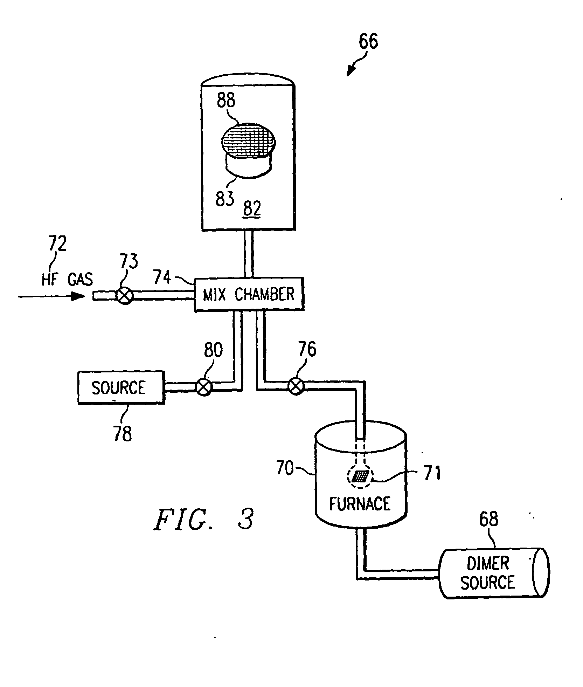

Referring to FIGURE 3, a processing system indicated generally at 66 is shown. System 66 is under vacuum base pressure of less than 10 millitor. System 66 comprises a dimer source 68 which is connected to a furnace 70. Furnace 70 also comprises a solid fluoride source 71, which introduces into furnace 70 a solid source of fluoride which may comprise, for example, cobalt fluoride or potassium fluoride. In the alternative, a gaseous fluoridating agent such as hydrogen fluoride may introduced from an HF source 72 through a valve 73 to a mix chamber 74. The dimer source 68 supplies the parylene-N, parylene-C or parylene-D dimer vapor by subliming the dimer by heating the dimer to on the order of 120° - 150°C. Furnace 70 is heated to the order of 500-580°C to disassociate the dimers and create the mixture of monomers and reactive fluoride compounds. This mixture is then passed to mixing chamber 74 through a valve 76. Other materials, such as dopants or other reactive or non-reactive agents may be supplied to the mix chamber 74 from a source 78 through a valve 80. As discussed previously, if a gaseous fluoride source such as HF source 72 is used, the mixing chamber 74 is used to fluoridate the reactive monomers.

The mixing chamber 74 is connected to a chamber 82. The entire system 66 is kept at a base pressure of less than 10 millitor. The pressure within chamber 82 increases during the deposition process but does not exceed 100 millitor. This pressure can be controlled by the temperature of dimer source 68 or by controlling the mass flow of the vapor entering the chamber 82. A chuck 83 within chamber 82 is capable of being temperature controlled between -80°C and 80°C. The chuck 83 inside the chamber 82 is cooled or heated to between -40° and 10°C to enable the monomers and fluoride to condense on the surface of a semiconductor wafer 88 placed on the chuck 83 within chamber 82.

The dimer source 68 provides an environment where the solid dimer can sublimate to a vapor state before being passed into furnace 70. The furnace 70 then disassociates the vapor dimer to the required reactive monomers. The fluoride source 72 then introduces the fluorinating agent into the furnace 70. The resulting reactive mixture is then condensed to form a mixture of per-fluorinated and non-fluorinated parylene on the outer surface of wafer 88 within CVD chamber 82. This mixed polymeric material exhibits a dielectric constant of the order of 2.3. It is thus comparable to the expensive and impractical parylene-F material. In addition, the mixed polymer intermetal dielectric of the present invention maintains good dimensional stability, high thermal stability, ease of pattern and etch for sub-micron features, low moisture absorption and permeation, good adhesion, low stress, good etch selectivity to metal, high thermal conductivity, high dielectric strength/low leakage current and good gap filling and planarization capability.

## Claims

1. A semiconductor device (10) comprising;
a first conductor (22) and a second conductor (24) disposed adjacent one another;
an intermetal body (46) formed from a dielectric material and disposed between the first metal conductor and the second metal conductor, **characterised in that** the dielectric material is a polymeric material consisting of a mixture of perfluorinated poly (para-xylylene) and non-perfluorinated poly (para-xylylene).

2. An intermetal dielectric material for integrated circuits consisting of a polymer mixture of
perfluorinated poly (para-xylylene) and non-perfluorinated poly (para-xylylene).

3. A method of forming an intermetal dielectric material for integrated circuits comprising:
sublimating poly (para-xylylene) dimers (60) and dissociating then into reactive poly (para-xylylene) monomers (62);
exposing the reactive poly (para-xylylene) monomers to a fluorinating agent; and
depositing the resulting mixture of perfluorinated and non-perfluorinated reactive poly (para-xylylene) monomers (64) on a substrate to form a polymeric dielectric material consisting of a mixture of perfluorinated poly (para-xylylene) and non-perfluorinated poly (para-xylylene).

4. The method of Claim 3, further comprising performing the depositing step at a low temperature.

5. The method of Claim 3 or Claim 4, wherein the exposing step comprises exposing the reacting monomers to a fluorinating agent comprising cobalt fluoride.

6. The method of Claim 3 or Claim 4, wherein the exposing step comprises exposing the reacting monomers to a fluorinating agent comprising potassium fluoride.

7. The method of Claim 3 or Claim 4, wherein the exposing step comprises exposing the reacting monomers to a fluorinating agent comprising hydrogen fluoride.

8. Apparatus for forming a dielectric material consisting of a mixture of perfluorinated poly (para-xylylene) and non-perfluorinated poly (para-xylylene) on a substrate (88) comprising:
a poly (para-xylylene) dimer source
a sublimation chamber (68), arranged for sublimating said poly (para-xylylene) diner source;
a dissociation furnace (70) coupled to the output of the sublimation chamber, the dissociation furnace configured to dissociate the poly (para-xylylene) dimers to poly (para-xylylene) monomers; and
a condensation chamber (82) coupled to the output of the furnace, the condensation chamber being configured to condense the poly (para-xylylene) monomers from the furnace output onto the substrate; **characterised in that** it further includes:
a fluoride source (71,72) arranged for fluoridation of said poly (para-xylylene) monomers prior to condensing, such that a mixture of perfluorinated poly (para-xylylene) and non-perfluorinated poly (para-xylylene) is obtained.

9. The apparatus of Claim 8:
wherein the fluoride source is a solid fluoride source situated in the furnace.

10. The apparatus of Claim 9, wherein the solid fluoride source comprises cobalt fluoride or potassium fluoride.

11. The apparatus of any of Claims 8 to 10, comprising:
means for introducing a gaseous fluoridating agent.

12. The apparatus of Claim 11, wherein the gaseous fluoridating agent comprises hydrogen fluoride.

13. The apparatus of Claim 11 or Claim 12 further comprising:
a mix chamber for exposing said monomers to said gaseous fluoridating agent.

14. The apparatus of any of Claims 8 to 13 further comprising:
a source for supplying dopants or other reactive or non-reactive materials to the mix chamber.

15. The apparatus of any of Claims 8 to 14, wherein the temperature of said condensation chamber is controllable between temperatures of the order of -80°C and 80°C.

16. A method of forming a semiconductor device comprising the steps of:
forming on a substrate first (22) and second (24) conductive elements spaced apart one from the other; and
depositing an intermetal dielectric material (46) between the first and second conductive elements consisting of a mixture of per-fluorinated poly (para-xylylene) and non-fluorinated poly (para-xylylene).

17. The method of Claim 16, wherein the step of depositing the intermetal dielectric further comprises:
sublimating a poly (para-xylylene) dimer vapor from a poly (para-xylylene) dimer source;
heating the poly (para-xylylene) dimer vapor to disassociate the poly (para-xylylene) monomers within the poly (para-xylylene) dimer;
introducing a fluoridating agent into the disassociated poly (para-xylylene) monomers; and
condensing the mixture of the fluoridating agent and the disassociated poly (para-xylylene) monomers onto the surface between the first and second conductive elements to form said intermetal dielectric material (46).

18. The method of Claim 17, wherein the step of introducing a fluoridating agent comprises the step of introducing a potassium fluoride source.

19. The method of Claim 17, wherein the step of introducing a fluoridating agent comprises the step of introducing a hydrogen fluoride source.

## Patentansprüche

1. Halbleiterbauelement (10) mit:
einem ersten Leiter (22) und einem zweiten Leiter (24), die angrenzend zueinander angeordnet sind,
einem Intermetallkörper (46), der aus einem dielektrischen Material besteht und zwischen dem ersten Metallleiter und dem zweiten Metallleiter angeordnet ist,
**dadurch gekennzeichnet, dass**
das dielektrische Material ein Polymermaterial ist, das aus einer Mischung von perfluoriertem Poly(para-xylylen) und nicht perfluoriertem Poly(para-xylylen) besteht.

2. Dielektrisches Intermetallmaterial für integrierte Schaltungen, das aus einer Polymermischung von perfluoriertem Poly(para-xylylen) und nicht perfluoriertem Poly(para-xylylen) besteht.

3. Verfahren zum Bilden eines dielektrischen Intermetallmaterials für integrierte Schaltungen mit den folgenden Schritten:
Sublimieren von Poly(para-xylylen)dimeren (60) und Dissoziieren von ihnen zu reaktiven Poly(para-xylylen)monomeren (62),
Einwirkenlassen eines Fluorierungsmittels auf die reaktiven Poly(para-xylylen)monomere und
Abscheiden der sich ergebenden Mischung perfluorierter und nicht perfluorierter reaktiver Poly(para-xylylen)monomere (64) auf ein Substrat zur Bildung eines dielektrischen Polymermaterials, welches aus einer Mischung von perfluoriertem Poly(para-xylylen) und nicht perfluoriertem Poly(para-xylylen) besteht.

4. Verfahren nach Anspruch 3, bei dem weiter der Abscheidungsschritt bei einer niedrigen Temperatur ausgeführt wird.

5. Verfahren nach Anspruch 3 oder 4, wobei in dem Schritt des Einwirkenlassens die reaktiven Monomere einem Fluorierungsmittel ausgesetzt werden, das Kobaltfluorid enthält.

6. Verfahren nach Anspruch 3 oder 4, wobei in dem Schritt des Einwirkenlassens die reaktiven Monomere einem Fluorierungsmittel ausgesetzt werden, welches Kaliumfluorid enthält.

7. Verfahren nach Anspruch 3 oder 4, wobei in dem Schritt des Einwirkenlassens die reaktiven Monomere einem Fluorierungsmittel ausgesetzt werden, das Fluorwasserstoff enthält.

8. Vorrichtung zum Bilden eines dielektrischen Materials, das aus einer Mischung von perfluoriertem Poly(para-xylylen) und nicht perfluoriertem Poly(para-xylylen) besteht, auf einem Substrat (88) mit:
einer Poly(para-xylylen)dimerquelle,
einer Sublimationskammer (68), die für das Sublimieren der Poly(para-xylylen)dimerquelle eingerichtet ist,
einem Dissoziationsofen (70), der mit dem Ausgang der Sublimationskammer verbunden ist, wobei der Dissoziationsofen für das Dissoziieren der Poly(para-xylylen)dimere zu Poly(para-xylylen)monomeren konfiguriert ist, und
einer Kondensationskammer (82), die mit dem Ausgang des Ofens verbunden ist, wobei die Kondensationskammer konfiguriert ist, um die Poly(para-xylylen)monomere von dem Ausgang des Ofens auf dem Substrat zu kondensieren,
**dadurch gekennzeichnet, dass** sie weiter aufweist:
eine Fluoridquelle (71, 72), die für das Fluorieren der Poly(para-xylylen)monomere vor dem Kondensieren eingerichtet ist, so dass eine Mischung von perfluoriertem Poly(para-xylylen) und nicht perfluoriertem Poly(para-xylylen) erhalten wird.

9. Vorrichtung nach Anspruch 8, wobei die Fluoridquelle eine feste Fluoridquelle ist, die sich in dem Ofen befindet.

10. Vorrichtung nach Anspruch 9, wobei die feste Fluoridquelle Kobaltfluorid oder Kaliumfluorid enthält.

11. Vorrichtung nach einem der Ansprüche 8 bis 10 mit:
Mitteln zum Einleiten eines gasförmigen Fluoridierungsmittels.

12. Vorrichtung nach Anspruch 11, wobei das gasförmige Fluoridierungsmittel Fluorwasserstoff enthält.

13. Vorrichtung nach Anspruch 11 oder 12, welche weiter aufweist:
eine Mischkammer, um das gasförmige Fluoridierungsmittel auf die Monomere einwirken zu lassen.

14. Vorrichtung nach einem der Ansprüche 8 bis 13, welche weiter aufweist:
eine Quelle zum Zuführen von Dotierungsmaterialien oder anderen reaktiven oder nicht reaktiven Materialien zu der Mischkammer.

15. Vorrichtung nach einem der Ansprüche 8 bis 14, wobei die Temperatur der Kondensationskammer zwischen Temperaturen in der Größenordnung von -80 °C und 80 °C steuerbar ist.

16. Verfahren zum Bilden eines Halbleiterbauelements mit den folgenden Schritten:
Bilden erster (22) und zweiter (24) leitfähiger Elemente, die voneinander beabstandet sind, auf einem Substrat und
Abscheiden eines dielektrischen Intermetallmaterials (46) zwischen den ersten und zweiten leitfähigen Elementen, das aus einer Mischung von perfluoriertem Poly(para-xylylen) und nicht perfluoriertem Poly(para-xylylen) besteht.

17. Verfahren nach Anspruch 16, wobei der Schritt des Abscheidens des Intermetalldielektrikums weiter aufweist:
Sublimieren eines Poly(para-xylylen)dimerdampfs von einer Poly(para-xylylen)dimerquelle,
Erwärmen des Poly(para-xylylen)dimerdampfs, um die Poly(para-xylylen)monomere innerhalb des Poly(para-xylylen)dimers zu dissoziieren,
Einleiten eines Fluoridierungsmittels in die dissoziierten Poly(para-xylylen)monomere und
Kondensieren der Mischung des Fluoridierungsmittels und der dissoziierten Poly(para-xylylen)monomere an der Oberfläche zwischen den ersten und zweiten leitfähigen Elementen, um das dielektrische Intermetallmaterial (46) zu bilden.

18. Verfahren nach Anspruch 17, wobei in dem Schritt des Einleitens eines Fluoridierungsmittels eine Kaliumfluoridquelle eingeleitet wird.

19. Verfahren nach Anspruch 17, wobei in dem Schritt des Einleitens eines Fluoridierungsmittels eine Fluoridwasserstoffquelle eingeleitet wird.

## Revendications

1. Dispositif à semi-conducteurs (10) comprenant :
un premier conducteur (22) et un deuxième conducteur (24) disposés au voisinage l'un de l'autre ;
un corps intermétallique (46) formé à partir d'un matériau diélectrique et disposé entre le premier conducteur métallique et le deuxième conducteur métallique, **caractérisé en ce que** le matériau diélectrique est un matériau polymérique se composant d'un mélange de poly(para-xylylène) perfluoré et de poly(para-xylylène) non perfluoré.

2. Matériau diélectrique intermétallique destiné à des circuits intégrés, se composant:
d'un mélange polymérique de poly(para-xylylène) perfluoré et de poly(para-xylylène) non perfluoré.

3. Procédé de formation d'un matériau diélectrique intermétallique destiné à des circuits intégrés, comprenant les étapes consistant à:
- sublimer des dimères de poly(para-xylylène) (60) et les dissocier en des monomères réactifs (62) de poly(para-xylylène);
- exposer les monomères réactifs de poly(para-xylylène) à un agent fluorant ; et
- déposer le mélange de monomères réactifs (64) de poly(para-xylylène) perfluoré et de poly(para-xylylène) non perfluoré qui en résulte sur un substrat afin de former un matériau diélectrique polymérique se composant d'un mélange de poly(para-xylylène) perfluoré et de poly(para-xylylène) non perfluoré.

4. Procédé selon la revendication 3, comprenant en outre le fait d'effectuer l'étape consistant à déposer à une température basse.

5. Procédé selon la revendication 3 ou la revendication 4, dans lequel l'étape consistant à exposer comprend l'étape consistant à exposer les monomères en cours de réaction à un agent fluorant comprenant le fluorure de cobalt.

6. Procédé selon la revendication 3 ou la revendication 4, dans lequel l'étape consistant à exposer comprend l'étape consistant à exposer les monomères en cours de réaction à un agent fluorant comprenant le fluorure de potassium.

7. Procédé selon la revendication 3 ou la revendication 4, dans lequel l'étape consistant à exposer comprend l'étape consistant à exposer les monomères en cours de réaction à un agent fluorant comprenant le fluorure d'hydrogène.

8. Appareil destiné à former un matériau diélectrique se composant d'un mélange de poly(para-xylylène) perfluoré et de poly(para-xylylène) non perfluoré sur un substrat (88), comprenant :
une source de dimères de poly(para-xylylène) ;
une chambre de sublimation (68), agencée de manière à sublimer ladite source de dimères de poly(para-xylylène) ;
un four de dissociation (70) couplé à la sortie de la chambre de sublimation, le four de dissociation étant configuré pour dissocier les dimères de poly(para-xylylène) en monomères de poly(para-xylylène) ; et
une chambre de condensation (82) couplée à la sortie du four, la chambre de condensation étant configurée pour condenser les monomères de poly(para-xylylène) provenant de la sortie de four sur le substrat ; **caractérisé en ce qu'**il comprend en outre :
une source de fluorure (71, 72) agencée pour la fluoration desdits monomères de poly(para-xylylène) avant la condensation, de telle manière qu'un mélange de poly(para-xylylène) perfluoré et de poly(para-xylylène) non perfluoré est obtenu.

9. Appareil selon la revendication 8 :
dans lequel la source de fluorure est une source solide de fluorure située dans le four.

10. Appareil selon la revendication 9, dans lequel la source solide de fluorure comprend le fluorure de cobalt ou le fluorure de potassium.

11. Appareil selon l'une quelconque des revendications 8 à 10, comprenant :
un moyen destiné à introduire un agent fluorant gazeux.

12. Appareil selon la revendication 11, dans lequel l'agent fluorant gazeux comprend le fluorure d'hydrogène.

13. Appareil selon la revendication 11 ou la revendication 12, comprenant en outre :
une chambre de mélange destinée à exposer lesdits monomères audit agent fluorant gazeux.

14. Appareil selon l'une quelconque des revendications 8 à 13, comprenant en outre :
une source destinée à alimenter en dopants ou autres matériaux réactifs ou non réactifs la chambre de mélange.

15. Appareil selon l'une quelconque des revendications 8 à 14, dans lequel la température de ladite chambre de condensation est contrôlable entre des températures de l'ordre de -80° à 80°.

16. Procédé de formation d'un dispositif à semi-conducteurs comprenant les étapes consistant à :
- former sur un substrat un premier (22) et un deuxième (24) éléments conducteurs séparés l'un de l'autre ; et
- déposer un matériau diélectrique intermétallique (46) entre le premier et le deuxième éléments conducteurs, se composant d'un mélange de poly(para-xylylène) perfluoré et de poly(para-xylylène) non fluoré.

17. Procédé selon la revendication 16, dans lequel l'étape consistant à déposer le diélectrique intermétallique comprend en outre les étapes consistant à :
- sublimer une vapeur de monomères de poly(para-xylylène) provenant d'une source de polymères de poly(para-xylylène) ;
- chauffer la vapeur de dimères de poly(para-xylylène) afin de dissocier les monomères de poly(para-xylylène) à l'intérieur des dimères de poly(para-xylylène) ;
- introduire un agent fluorant vers l'intérieur des monomères de poly(para-xylylène) dissociés ; et
- condenser le mélange de l'agent fluorant et les monomères de poly(para-xylylène) dissociés sur la surface entre le premier et le deuxième éléments conducteurs de manière à former ledit matériau de diélectrique intermétallique (46).

18. Procédé selon la revendication 17, dans lequel l'étape consistant à introduire un agent fluorant comprend l'étape consistant à introduire une source de fluorure de potassium.

19. Procédé selon la revendication 17, dans lequel l'étape consistant à introduire un agent fluorant comprend l'étape consistant à introduire une source de fluorure d'hydrogène.
